# EUROPÄISCHE PATENTSCHRIFT

(11) **EP 0 941 643 B1**
(45) Veröffentlichungstag und Bekanntmachung des Hinweises auf die Patenterteilung: **06.09.2000**
(21) Anmeldenummer: 97951096.3
(22) Anmeldetag: 25.11.1997
(51) Int. Cl.: H05K 7/10

(54) **SOCKEL FÜR EINE INTEGRIERTE SCHALTUNG**
BASE FOR AN INTEGRATED CIRCUIT
SOCLE POUR CIRCUIT INTEGRE

(30) Priorität: 26.11.1996 DE 29620593 U
(43) Veröffentlichungstag der Anmeldung: 15.09.1999
(73) Patentinhaber: SIEMENS AKTIENGESELLSCHAFT, 80333 München (DE)
(72) Erfinder: KLEIN, Klaus, D-76287 Rheinstetten (DE)
(86) Internationale Anmeldenummer: DE9702758
(87) Internationale Veröffentlichungsnummer: WO9824284

(56) Entgegenhaltungen:
- DE-A- 3 922 461
- DE-A- 4 420 527
- DE-U- 8 716 007
- GB-A- 2 293 502
- US-A- 4 679 318
- US-A- 5 303 466
- US-A- 5 473 510

## Beschreibung

Die Erfindung betrifft einen Sockel für eine integrierte Schaltung nach dem Oberbegriff des Anspruchs 1.

Ein Sockel gemäß dem Oberbegriff des Anspruchs 1 ist, z.B., aus US-A-4 679 318 bekannt.

Hochkomplexe und kostenintensive integrierte Schaltungen, z. B. Prozessoren, werden als Bauelemente in hochpoligen, standardisierten Gehäusen, z. B. PGA (Pin Grid Array) oder SPGA (Staggered Pin Grid Array), angeboten, vgl. z. B. US-A-5 303 466. Zur Montage auf einer Leiterplatte werden Anschlußelemente der integrierten Schaltung, sogenannte Pins, wahlweise direkt in Durchkontaktierungen der Leiterplatte eingesteckt und mit diesen durch Löten elektrisch verbunden oder die integrierte Schaltung wird lösbar in einen Sockel eingesetzt, der selbst auf die Leiterplatte gelötet ist und die elektrischen Verbindungen zwischen Anschlußelementen der integrierten Schaltung und Anschlußelementen der Leiterplatte herstellt. Mit dem höheren Aufwand bei der Verwendung eines Sockels als zusätzlichem Bauelement wird der Vorteil erreicht, daß ein späterer Austausch der integrierten Schaltung, z. B. zur Reparatur oder zur Aufrüstung mit einem leistungsfähigeren Bauelement, leicht durchgeführt werden kann. Bei direkt eingelöteter integrierter Schaltung wäre dieser nicht oder nur sehr aufwendig möglich.

Aus dem DE-GM 87 16 007 ist ein derartiger Sockel bekannt, der zusätzlich zur Kühlung der integrierten Schaltung mit einem Kühlkörper, der in einen Trägerrahmen eingeschnappt wird, ausgestattet ist. Kontaktelemente des Sockels zur Kontaktierung der Leiterplattenanschlußelemente sind wie diejenigen der integrierten Schaltung als Pins für Durchsteckmontage ausgeführt. Auch zur Montage des Sockels werden somit Durchkontaktierungen in der Leiterplatte benötigt.

Aus der DE 39 22 461 C2 ist ein Abschirmgehäuse bekannt, das zur Unterbringung verschiedener Schaltungen verwendet werden kann. Das Gehäuse ist im wesentlichen quaderförmig und weist eine offene Seite auf, die, wenn es auf einer Leiterplatte montiert ist, durch diese verschlossen wird. Befestigt wird das Abschirmgehäuse an der Leiterplatte, indem vier an dem unteren Rand des Abschirmgehäuses ausgebildete Montagebeine in Montageöffnungen der Leiterplatte eingeführt und umgebogen oder verlötet werden. In dem Abschirmgehäuse untergebrachte Schaltungen werden direkt mit der Leiterplatte verlötet. Durch dieses Abschirmgehäuse wird ein ohnehin schon schwieriger Austausch eingesetzter Bauelemente in nachteiliger Weise zusätzlich erschwert. Ein weiterer Nachteil ist, daß sich die Kapselung der Bauelemente negativ auf die Entwärmung auswirkt, die insbesondere bei komplexen integrierten Schaltungen gewährleistet werden muß.

Der Erfindung liegt die Aufgabe zugrunde, einen Sockel für eine integrierte Schaltung zu schaffen, der einen leichten Austausch eingesetzter integrierter Schaltungen ermöglicht und bei welchem auf Durchkontaktierungen als Anschlußelemente der Leiterplatte verzichtet werden kann.

Zur Lösung dieser Aufgabe weist der neue Sockel der eingangs genannten Art die im kennzeichnenden Teil des Anspruchs 1 angegebenen Merkmale auf. Vorteilhafte Weiterbildungen sind in den Unteransprüchen beschrieben.

Die Erfindung hat den Vorteil, daß auch integrierte Schaltungen mit PGA- oder SPGA-Anschlußformen, die eigentlich für eine Durchsteckmontage konzipiert sind, auf eine Leiterplatte in reiner SMD (Surface Mounted Device)-Technologie bestückt werden können, ohne daß hierbei das SMD-Prinzip durchbrochen werden muß. Mit diesem Sockel können integrierte Schaltungen für Durchsteckmontage auch bei Leiterplattentechnologien bestückt werden, die keine Durchkontaktierungen als Anschlußelemente zulassen. Dies ist beispielsweise bei Leiterplatten mit einer Mehrfach-Oberflächenverdrahtung der Fall, bei denen durch partielle Durchkontaktierungen zur Verbindung von Leitungen verschiedener Lagen die Anzahl der Signallagen drastisch reduziert wird. Durch die nun mögliche Anwendung einer reinen SMD-Technologie entfallen die Verfahrensschritte, die bei einer Mischtechnik zum Bestücken und Löten von Bauelementen in Durchsteckmontage erforderlich wären. D. h., eine Baugruppe muß im Herstellungsprozeß nicht mehr an einen Handbestückplatz und über ein Schwallbad geführt werden. Der Herstellungsaufwand ist somit erheblich verringert.

Zur Vermeidung zu hoher Ausziehkräfte bei der Entnahme der integrierten Schaltung können Sockeleinsätze verwendet werden, die auf der Seite der integrierten Schaltung als ZIF (Zero Insertion Force)- oder LIF (Low Insertion Force)-Version ausgeführt sind. Damit bei anderen Sockeleinsätzen die Ausziehkräfte nicht auf die Anschlußelemente der Leiterplatte wirken, kann vorteilhaft ein Aushebewerkzeug verwendet werden, das sich auf dem Sockel abstützt, oder der Sockeleinsatz kann auf der Leiterplatte mit gesonderten Befestigungselementen, z. B. Schrauben, gehalten werden.

Wenn der Sockel ein zur Leiterplatte hin einseitig offenes Abschirmgehäuse mit einem Rahmen und einem Deckel zur Aufnahme der integrierten Schaltung und des Sockeleinsatzes aufweist, wobei der Deckel zur Entnahme der integrierten Schaltung geöffnet werden kann, hat dies den Vorteil, daß die integrierte Schaltung bereits nach Öffnen des Gehäusedeckels zugänglich ist und aus einem Sockeleinsatz - eventuell unter Zuhilfenahme eines einfachen Aushebewerkzeuges - entnommen werden kann. Zum leichten Öffnen des Deckels kann dieser beispielsweise mit Schrauben, Klammern oder einer Rastverbindung befestigt werden. Da auf der Leiterplattenseite eine SMD-Anschlußtechnik eingesetzt wird, ist es vorteilhaft, den Sockeleinsatz mit verklemmten Kontaktelementen in seiner Lage durch den Sockelrahmen, der auf der Leiterplatte befestigt ist, zu sichern. Dadurch wird vermieden, daß bei der Entnahme der integrierten Schaltung auftretende Ausziehkräfte auf die elektrischen Kontaktstellen an den Anschlußelementen der Leiterplatte wirken und diese beschädigen. Durch eine Schräge an der Innenseite des Sockelrahmens kann eine leichte Zugänglichkeit der integrierten Schaltung für ein Aushebewerkzeug erreicht werden. Wird als Aushebewerkzeug beispielsweise ein Schraubendreher verwendet, so dient der Sockelrahmen in vorteilhafter Weise als nahe am Bauelement liegendes Gegenlager mit guter Hebelwirkung. Zusätzlich ist die Gestaltung des Sockelrahmens so ausgelegt, daß ein spezielles Aushebewerkzeug, welches auch zum Eindrücken des Bauelementes genutzt werden kann, einsetzbar ist. Durch einen aus mehreren Teilen zusammengesetzten Sockelrahmen können vorteilhaft verschiedene Rahmentypen nach einem Baukastenprinzip modular aufgebaut werden. Dies wirkt sich nicht negativ auf die Abschirmeigenschaften des Gehäuses bezüglich elektromagnetischer oder elektrostatischer Einflüsse aus, wenn sich die Teile an den Stoßstellen überlappen. Zur besseren Entwärmung können Deckel und Rahmen des Sockels als mit Kühlrippen versehene Kühlkörper ausgebildet werden. Für einen guten Wärmekontakt zwischen Deckel und integrierter Schaltung liegt dieser formschlüssig, eventuell thermisch gekoppelt durch eine Wärmeleitpaste, auf der Oberseite der integrierten Schaltung auf. Auch zwischen Deckel und Rahmen ist die Verwendung einer Wärmeleitpaste vorteilhaft. Die bei der Entwärmung aktive Oberfläche kann weiter vergrößert werden, indem eine Bodenplatte auf der gegenüberliegenden Seite der Leiterplatte befestigt und mit Rahmen und Deckel des Gehäuses thermisch gekoppelt wird. Durch Zusatzmaßnahmen auf der Leiterplatte, z. B. großflächige Kupferflächen beidseitig, die mit möglichst vielen Durchkontaktierungen miteinander verbunden sind, können Wärmeübergang und Ground-Verbindung zusätzlich verbessert werden. Die Bodenplatte kann auch als Gegenlager bei der Montage eines Sockeleinsatzes zum Verklemmen der Kontaktelemente dienen. Bei BGA- oder SGA-Bauform des Sockeleinsatzes ist die Bodenplatte zur besseren Entwärmung und als Gegenlager vorteilhaft eben, d. h. ohne eine Ausnehmung, ausgeführt.

Anhand der Zeichnungen, die ein Ausführungsbeispiel der Erfindung darstellen, werden im folgenden die Erfindung sowie Ausgestaltungen und Vorteile näher erläutert.

Es zeigen:
- Figur 1: einen Sockel in Explosionsdarstellung,
- Figur 2: ein Schnittbild durch einen Sockel,
- Figur 3: einen Sockeleinsatz mit kraftschlüssiger Klemmung eines Kontaktelementes in einem Schnittbild,
- Figur 4: einen Sockeleinsatz mit formschlüssiger Klemmung,
- Figur 5: einen Sockeleinsatz mit kraft- und formschlüssiger Klemmung eines Kontaktelementes und
- Figur 6: einen Sockeleinsatz in SGA-Ausführung.

Gleiche Teile sind mit gleichen Bezugszeichen versehen.

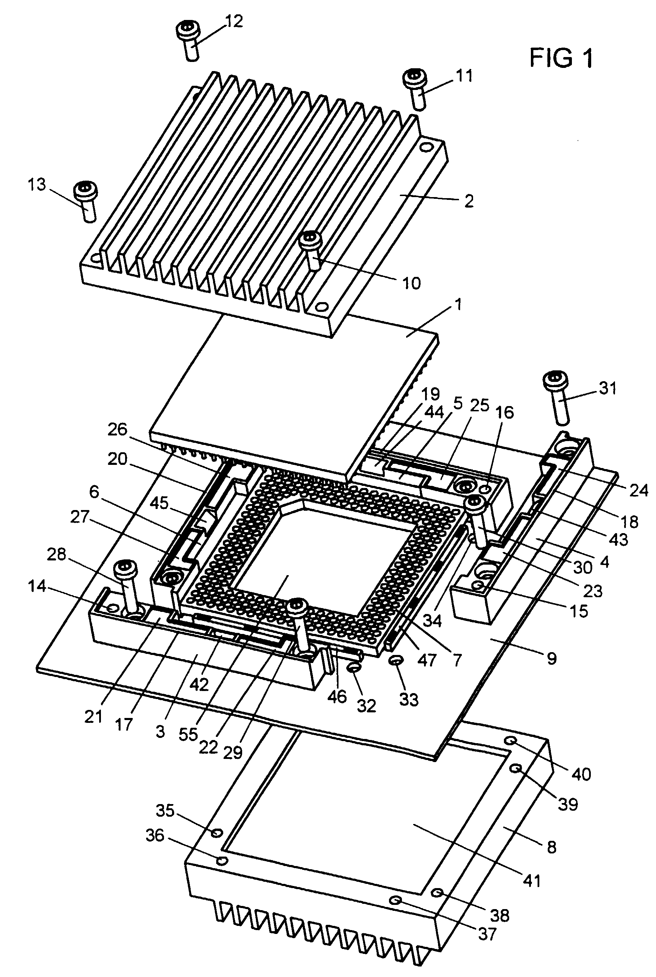

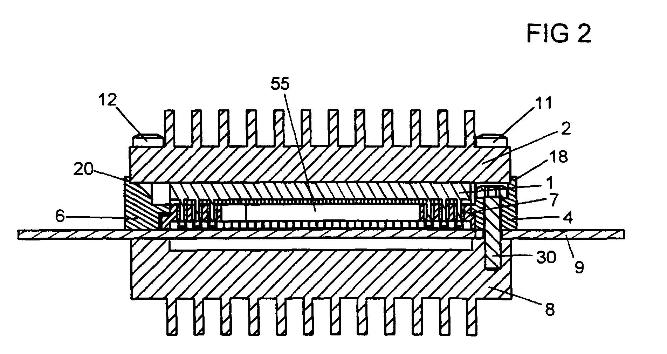

Gemäß Figur 1 besteht ein Sockel für eine integrierte Schaltung 1 im wesentlichen aus einem Deckel 2, einem hier aus vier Teilen 3, 4, 5 und 6 zusammengesetzten Rahmen, einem Sockeleinsatz 7 und einem Boden 8. Der Deckel 2 ist als Kühlkörper ausgeführt und mit Kühlrippen an seiner Oberseite versehen, so daß er entsprechend der Luftführung in dem Gerät, in welchem eine mit den gezeigten Bauteilen bestückte Leiterplatte 9 eingesetzt werden soll, optimal ausgerichtet werden kann. Befestigt wird der Deckel an dem Sockelrahmen mit vier im Bereich seiner Ecken angeordneten Schrauben 10 ... 13. Dazu sind in den Teilen 3 ... 6 des Sockelrahmens zu den Schrauben 10 ... 13 korrespondierende Öffnungen mit Innengewinde angebracht, von denen in Figur 2 nur die Öffnungen 14, 15 und 16 sichtbar sind. Damit das Abschirmgehäuse auch an den Stoßstellen zwischen dem Deckel 2 und dem Sockelrahmen strahlungsdicht ist, weisen die Teile 3 ... 6 jeweils einen Kragen 17, 18, 19 bzw. 20 auf, der den Deckel 2 an den zugeordneten Kantenabschnitten seitlich etwas überragt. Der Sockelrahmen kann aus wirtschaftlichen Gründen auch als einteiliger Rahmen mit weniger Befestigungspunkten auf der Leiterplatte ausgelegt werden. Im montierten Zustand liegt der Deckel 2 eben auf der Oberseite der integrierten Schaltung 1 auf. Dadurch wird bereits eine gute Wärmekopplung zwischen integrierter Schaltung 1 und Deckel 2 erreicht. Zur weiteren Verbesserung der Wärmekopplung kann die Oberseite der integrierten Schaltung 1 bei der Montage mit einer Wärmeleitpaste oder einem ähnlichen Mittel, z. B. Wärmeleitfolie, versehen werden. Um auch zwischen Sockelrahmen und Deckel 2 eine gute Wärmekopplung zu ermöglichen, sind in den Teilen 3 ... 6 jeweils zwei Ausnehmungen angebracht, die als Depot für Wärmeleitpaste dienen. In der Figur 1 sind von diesen lediglich die Ausnehmungen 21 ... 27 sichtbar. Die Teile 3 ... 6 des Sockelrahmens sind an den Stoßstellen mit Überlappungen versehen, damit auch über diese Stoßstellen keine elektromagnetischen oder elektrostatischen Einstreuungen das Abschirmgehäuse durchdringen können. Der Sockelrahmen wird mit acht Schrauben befestigt, die durch Öffnungen in der Leiterplatte geführt und in dazu korrespondierende Bohrungen mit Innengewinde im Boden 8 eingedreht werden. In Figur 1 sind lediglich die Schrauben 28 ... 31, die Öffnungen 32, 33 und 34 sowie Bohrungen 35 ... 40 dargestellt. Der Boden 8 ist ebenfalls als Kühlkörper ausgebildet und mit Kühlrippen versehen. An seiner Oberseite weist er eine Ausnehmung 41 auf. Der Boden 8 kann auch eben ausgeführt und als Support oder Gegenlager benutzt werden, wenn ein Sockeleinsatz 7 mit Kontaktelementen verwendet wird, die durch Andrücken des Sockeleinsatzes 7 gegen die Leiterplatte 9 in ihren Führungen verklemmt werden. Wenn die Wärmekopplung zwischen Boden 8 und Sockelrahmen über die acht Befestigungsschrauben und die Kontaktstellen an der Leiterplatte 9 hinweg noch nicht ausreicht, können auf der Oberseite der Kanten des Bodens 8 wie auch auf der Unterseite der Teile 3 ... 6 des Sockelrahmens weitere, in Figur 1 nicht dargestellte Ausnehmungen als Depot für Wärmeleitpaste angebracht werden. Da auf beiden Seiten der Leiterplatte 9 Kühlkörper vorgesehen sind, wird die Gesamtbauhöhe des Sockels quasi auf beide Seiten der Leiterplatte 9 verteilt. Somit wird auf jeder Seite nur eine geringe Bauhöhe über der Leiterplatte 9 zur Realisierung der Entwärmung der integrierten Schaltung 1 benötigt. In bestimmten Fällen kann dies von entscheidender Bedeutung sein, beispielsweise wenn auf der Bestückseite der Leiterplatte 9 nur eine geringe Bauhöhe zulässig ist, die zur Entwärmung mit nur einem Kühlkörper auf der Bestückseite im lüfterlosen Betrieb nicht ausreichen würde. Für eine leichte Entnehmbarkeit der integrierten Schaltung 1, z. B. zur Reparatur oder Aufrüstung des elektronischen Geräts, sind an den Teilen 3 ... 6 des Sockelrahmens schräg verlaufende Ausnehmungen 42, 43, 44 bzw. 45 vorhanden, in welche ein Aushebewerkzeug, beispielsweise eine Schraubendreherklinge, derart eingeführt werden kann, daß es die Unterseite der integrierten Schaltung 1 hintergreift. Gleichzeitig dienen die Teile 3 ... 6 eventuell als Gegenlager, um eine Hebelwirkung zu erzeugen. Zur Lagesicherung des Sockeleinsatzes 7, d. h. damit dieser beim Ausziehen der integrierten Schaltung 1 nicht von der Leiterplatte 9 gelöst wird, sind an den Teilen 3 ... 6 des Sockelrahmens jeweils Stege, die in der Figur 1 verdeckt sind, vorgesehen, welche im montierten Zustand auf den Sockeleinsatz 7 nahezu völlig umlaufenden Kanten - in Figur 1 sind lediglich die Kanten 46 und 47 sichtbar - zu liegen kommen.

In Figur 2, einem Schnittbild durch einen montierten Sockel nach Figur 1, ist besonders gut die oben beschriebene Überlappung der Kragen 18 und 20 von Teilen 4 bzw. 6 des Sockelrahmens an den Seiten des Deckels 2 sichtbar. Deutlich wird auch die Verteilung der Gesamtbauhöhe des Sockels auf beide Seiten der Leiterplatte 9, wodurch eine jeweils niedrige Höhe auf Ober- und Unterseite bei guter Entwärmung der integrierten Schaltung 1 erreicht wird. Durch im Bereich des Sockelrahmens plazierte Kontaktstellen auf der Leiterplatte 9 kann der Sockelaufbau in das Ground-Konzept, d. h. die Führung der Schirm- und Bezugsmasse im elektronischen Gerät, eingebunden werden.

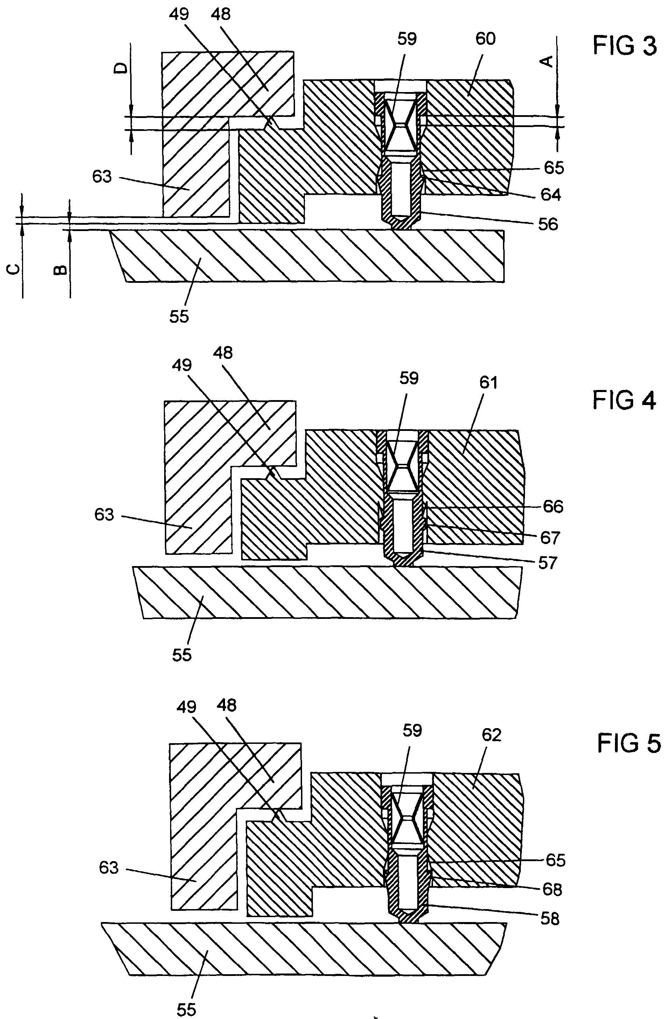

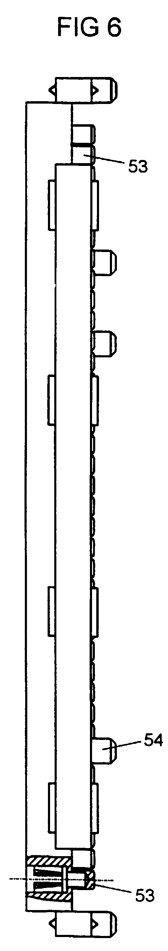

Die Figuren 3, 4 und 5 verdeutlichen verschiedene Varianten zur Klemmung eines Kontaktelementes im Sockeleinsatz nach dem Andrücken auf eine Leiterplatte 55. Dargestellt ist jeweils die Situation unmittelbar vor einem Andrücken. Kontaktelemente 56, 57 bzw. 58 sind jeweils mit einer Kontaktfeder 59 zur Kontaktierung des Anschlußelements einer einzusetzenden integrierten Schaltung versehen. In einen Kunststoffkörper 60, 61 oder 62 werden die Kontaktelemente 56, 57 bzw. 58 von oben eingesetzt und durch eine Rastverbindung in ihrer Endlage gegen ein Herausfallen gesichert. Auf die Leiterplatte 55 angedrückt und dort befestigt werden die Kunststoffkörper 60, 61 und 62 jeweils mit einem Rahmen 63, der direkt auf der Leiterplatte befestigbar ist. Zur Erläuterung des Toleranzausgleichs sind in Figur 3 Maße A, B, C und D eingezeichnet. Um das Maß A sind die Kontaktelemente 56, 57 und 58 bei allen drei Varianten einer Klemmung in ihren Führungen verschiebbar, um Höhentoleranzen der Anschlußelemente auf der Leiterplatte 55 ausgleichen zu können. Das Maß B bestimmt den Weg, um welchen die Kontaktelemente 56, 57 und 58 beim Andrücken der Sockeleinsätze gegen die Leiterplatte 55 aus ihrer Endlage im Kunststoffkörper 60, 61 bzw. 62 verschoben werden, um eine Klemmwirkung in der Führung zu erzeugen. Zur Lagesicherung des Sockeleinsatzes im Sockel ist am Rahmen 63 ein Steg 48 angebracht, dessen Unterseite auf der Oberseite einer Kante der Kunststoffkörper 60, 61 bzw. 62 der Sockeleinsätze aufliegt. Zum Ausgleich von Fertigungstoleranzen sowie zur Erzeugung einer definierten Andruckkraft sind an der Oberseite der Kante der Kunststoffkörper 60, 61 und 62 jeweils nach oben weisende, dachkantförmige Fortsätze 49 vorgesehen. Beim Andrücken der Sockeleinsätze gegen die Leiterplatte 55 wird die Höhe D der Fortsätze um das Maß C zum Toleranzausgleich durch eine Verformung der Fortsätze verringert. In der Variante gemäß Figur 3 wird eine kraftschlüssige Klemmung des Kontaktelements 56 im Kunststoffkörper 60 erreicht, indem sich beim Andrücken ein umlaufender Kragen 64 des Kontaktelements 56 in eine konusförmige Schräge 65 des Kunststoffkörpers 60 hineindrückt und dort durch gegenseitiges Verklemmen gehalten wird. Eine formschlüssige Klemmung ergibt sich bei der Variante nach Figur 4, bei welcher ein zunächst hohlkegelförmiger Kragen 66 am Schaft des Kontaktelements 57 anliegt und beim Andrücken gegen die Leiterplatte 55 durch einen umlaufenden Kragen 67 des Kontaktelements 57 deformiert wird. Dadurch wird in dem Kunststoffteil 61 eine formschlüssige Verbindung zum Kragen 67 gebildet. Bei der in Figur 5 dargestellten dritten Variante ist das Kontaktelement 58 mit einem umlaufenden, deformierbaren Spitzkragen 68 versehen, der sich in das Kunststoffteil 62 hineindrückt und eine formschlüssige sowie kraftschlüssige Klemmung bewirkt. Bei allen drei in den Figuren 3, 4 und 5 dargestellten Varianten ist somit sichergestellt, daß beim Ausziehen einer integrierten Schaltung 1, die als PGA- oder SPGA-Bauelement ausgeführt sein kann, keine Kräfte auf die Lötstellen an der Leiterplatte 55 wirken.

Kontaktelemente 53 des in Figur 6 dargestellten Sockeleinsatzes werden an Anschlußflächen der Leiterplatte angelötet, die sich auf der Oberfläche der Leiterplatte befinden. Bei der hier verwendeten SMT (Surface Mounted Technology) ist es vorteilhaft, wenn der Sockeleinsatz durch Zentrierstifte 54, zu denen die Leiterplatte korrespondierende Bohrungen aufweist, vor dem Lötvorgang exakt positioniert wird. Für einen besseren Toleranzausgleich sind bei der SGA-Ausführung gemäß Figur 6 oder einer BGA-Ausführung die Kontaktelemente 53 in Steckrichtung der Zentrierstifte 54 schwimmend gelagert. Durch entsprechende Gestaltung der Kontaktelemente und des Sockeleinsatzes kann dieser nach dem Lötprozeß durch den Sockelrahmen oder ein anderes Werkzeug auf die Leiterplatte gepreßt werden. Z. B. durch Klemmwirkung können die Kontaktelemente kraftschlüssig in ihrer Endlage im Sockeleinsatz zusätzlich befestigt werden. Ziehkräfte wirken danach nicht mehr auf die Lötanschlüsse.

Da durch das Abschirmgehäuse des Sockels und eventuell durch eine Masselage in der Leiterplatte eine in bezug auf elektromagnetische und elektrostatische Einflüsse hermetisch dicht abgeschlossene "Insel" gebildet wird, die wahlweise in ein Ground-Konzept fest eingebunden oder auch induktiv oder kapazitiv angekoppelt werden kann, lassen sich bei einer geänderten Formgebung mit vergrößertem Innenraum des Sockels oder im Freiraum 55 innerhalb des Sockeleinsatzes 7 weitere bezüglich elektromagnetischer Abschirmung kritische Bauelemente, z. B. Quarze, VCO- oder Taktschaltungen, in das Abschirmgehäuse integrieren. Dies ist besonders günstig bei Bauelementen, die der integrierten Schaltung funktionell zugeordnet sind.

In vorteilhafter Weise kann der Sockel bei Austausch lediglich des Sockeleinsatzes 7 für integrierte Schaltungen unterschiedlicher Gehäusebauformen und unterschiedlicher elektrischer Anschlußelemente verwendet werden.

In diesem Ausführungsbeispiel wurde ein Sockel mit einem Sockeleinsatz und einem Abschirmgehäuse beschrieben. Sofern auf ein Abschirmgehäuse verzichtet wird, kann ein Sockel in einer anderen Ausführungsform der Erfindung auch lediglich aus einem Sockeleinsatz mit den Kontaktelementen bestehen.

## Patentansprüche

1. Sockel für eine integrierte Schaltung, der zur Montage auf einer Leiterplatte (9) geeignet und mit einem Sockeleinsatz (7) mit Kontaktelementen (53) versehen ist, durch welche elektrische Verbindungen zwischen für eine Durchsteckmontage in einer Leiterplatte ausgebildeten Pins der integrierten Schaltung (1) und Anschlußelementen der Leiterplatte (9) herstellbar sind, wobei die Kontaktelemente (53) zur Kontaktierung der Anschlußelemente auf der Leiterplatte (9) in einer Oberflächenmontagetechnik ausgebildet sind und zum Ausgleich von Höhentoleranzen der Anschlußelemente auf der Leiterplatte (9) in dem Sockeleinsatz (7) bei der Montage verschiebbar sind, dadurch gekennzeichnet, daß die Führung der Kontaktelemente (53) im Sockeleinsatz (7) derart ausgebildet ist, daß sie nach einem Andrücken des Sockeleinsatzes gegen eine Leiterplatte (9) durch ein Verklemmen der Kontaktelemente (53) im Sockeleinsatz (7) gegen Verschieben gesichert sind.

2. Sockel nach Anspruch 1, **dadurch gekennzeichnet,** daß die Kontaktelemente (53) in dem Sockeleinsatz (7) korrespondierend zu einer Pinanordnung bei der integrierten Schaltung (1) nach Art eines PGA (Pin Grid Array) oder SPGA (Staggered Pin Grid Array) reihenförmig angeordnet sind.

3. Sockel nach Anspruch 1 oder 2, **dadurch gekennzeichnet,** daß die Kontaktelemente (53) zur Kontaktierung der Anschlußelemente auf der Leiterplatte (9) als BGA (Ball Grid Array) oder SGA (Stud Grid Array) ausgebildet sind.

4. Sockel nach einem der vorhergehenden Ansprüche, **dadurch gekennzeichnet,** daß der Sockel ein zur Leiterplatte (9) hin einseitig offenes Abschirmgehäuse mit einem Rahmen (3 ... 6) und einem Deckel (2) zur Aufnahme der integrierten Schaltung (1) und des Sockeleinsatzes (7) aufweist, wobei der Deckel (2) zur Entnahme der integrierten Schaltung (1) geöffnet werden kann.

5. Sockel nach Anspruch 4, **dadurch gekennzeichnet,** daß der Sockelrahmen (3 ... 6) auf der Leiterplatte (9) befestigbar ist und im montierten Zustand den Sockeleinsatz (7) in seiner Lage sichert.

6. Sockel nach Anspruch 5, **dadurch gekennzeichnet,** daß zur Befestigung des Sockelrahmens an der Leiterplatte Schrauben (28 ... 31) vorgesehen sind.

7. Sockel nach Anspruch 5 oder 6, **dadurch gekennzeichnet,** daß der Sockelrahmen zur Lagesicherung des Sockeleinsatzes auf seiner Innenseite mit einem im wesentlichen umlaufenden Steg (48) versehen ist, an dessen Unterseite im montierten Zustand die Oberseite einer dazu korrespondierenden umlaufenden Kante (46, 47) des Sockeleinsatzes (7) anliegt.

8. Sockel nach einem der Ansprüche 4 bis 7, **dadurch gekennzeichnet,** daß der Sockelrahmen an seiner Innenseite mit zumindest einer Ausnehmung (42 ... 45), insbesondere einer Schräge, versehen ist, die für ein Aushebewerkzeug, insbesondere einen Schraubendreher, einen Zugriff zum Ausheben der integrierten Schaltung (1) ermöglicht.

9. Sockel nach einem der Ansprüche 4 bis 8, **dadurch gekennzeichnet,** daß der Sockelrahmen rechteckig aus mehreren sich jeweils im wesentlichen entlang der geraden Kanten erstreckenden Teilen (3 ... 6) zusammengesetzt ist, wobei die Teile an den Stoßstellen, die sich im Bereich der Rahmenecken befinden, einander überlappen.

10. Sockel nach einem der Ansprüche 4 bis 9, **dadurch gekennzeichnet,** daß der Deckel (2) als mit Kühlrippen versehener Kühlkörper für die integrierte Schaltung ausgebildet ist.

11. Sockel nach Anspruch 10, **dadurch gekennzeichnet,** daß der Sockelrahmen als mit Kühlrippen versehener Kühlkörper ausgebildet ist.

12. Sockel nach Anspruch 10 oder 11, **dadurch gekennzeichnet,** daß der Sockelrahmen an den Auflageflächen des Deckels Kammern (21 ... 27) für Wärmeleitpaste zur thermischen Kopplung von Rahmen und Deckel aufweist.

13. Sockel nach einem der Ansprüche 4 bis 12, **dadurch gekennzeichnet,** daß Sockelrahmen und Deckel an den Stoßstellen einander überlappen.

14. Sockel nach einem der Ansprüche 4 bis 13, **dadurch gekennzeichnet,** daß eine Bodenplatte (8) zur Montage auf der dem Rahmen und dem Deckel gegenüberliegenden Seite der Leiterplatte (9) vorgesehen ist.

15. Sockel nach Anspruch 14, **dadurch gekennzeichnet,** daß die Bodenplatte (8) als mit Kühlrippen versehener Kühlkörper ausgebildet und im montierten Zustand durch Ausnehmungen (32, 33, 34) der Leiterplatte hindurch über den Sockelrahmen und/oder den Sockeldeckel mit der integrierten Schaltung wärmegekoppelt ist.

16. Sockel nach Anspruch 14 oder 15, **dadurch gekennzeichnet,** daß er durch Einklemmen der Leiterplatte zwischen Sockelrahmen und Bodenplatte befestigbar ist.

17. Sockel nach Anspruch 16, **dadurch gekennzeichnet,** daß Sockelrahmen und Bodenplatte mit durch die Leiterplatte ragenden Schrauben (28 ... 31) zusammenschraubbar sind.

18. Sockel nach einem der Ansprüche 14 bis 17, **dadurch gekennzeichnet,** daß die Bodenplatte eine Ausnehmung (41) für durch die Leiterplatte hindurchragende Anschlußelemente oder Bauelemente auf der Unterseite der Leiterplatte (9) aufweist.

## Claims

1. Base for an integrated circuit, which is suitable for assembly on a printed-circuit board (9) and is provided with a base insert (7) having contact elements (53) by which electrical connections can be produced between pins of the integrated circuit (1) that are constructed for a push-through assembly in a printed-circuit board, and connection elements of the printed-circuit board (9), wherein the contact elements (53) for contacting the connection elements on the printed-circuit board (9) are constructed in a surface mounted technology and for compensation of vertical tolerances of the connection elements on the printed-circuit board (9) in the base insert (7) can be displaced during the assembly, characterised in that the guide of the contact elements (53) in the base insert (7) is constructed in such a way that after the base insert has been pressed against a printed-circuit board (9), they are secured against displacement by a clamping of the contact elements (53) in the base insert (7).

2. Base according to claim 1, characterised in that the contact elements (53) are arranged in rows in the base insert (7) in a manner corresponding to a pin arrangement in the integrated circuit (1) in the style of a PGA (Pin Grid Array) or SPGA (Staggered Pin Grid Array).

3. Base according to claim 1 or 2, characterised in that the contact elements (53) for contacting the connection elements on the printed-circuit board (9) are constructed as a BGA (Ball Grid Array) or SGA (Stud Grid Array).

4. Base according to one of the preceding claims, characterised in that the base has a screening housing which is open on one side towards the printed-circuit board (9) and has a frame (3 ... 6) and a cover (2) for receiving the integrated circuit (1) and the base insert (7), the cover (2) being able to be opened for removal of the integrated circuit (1).

5. Base according to claim 4, characterised in that the base frame (3 ... 6) can be fastened on the printed-circuit board (9) and in the mounted state secures the base insert (7) in its position.

6. Base according to claim 5, characterised in that screws (28 ... 31) are provided in order to fasten the base frame to the printed-circuit board.

7. Base according to claim 5 or 6, characterised in that the base frame for securing the position of the base insert is provided, on the inside, with a substantially circumferential web (48), against the underside of which, in the mounted state, rests the upper side of a corresponding circumferential edge (46, 47) of the base insert (7).

8. Base according to one of claims 4 to 7, characterised in that the base frame is provided, on the inside, with at least one recess (42 ... 45), in particular a bevel, which allows a lifting-out tool, in particular a screwdriver, access for lifting out the integrated circuit (1).

9. Base according to one of claims 4 to 8, characterised in that the base frame is made up in rectangular form from a plurality of portions (3 ... 6) each extending substantially along the straight edges, the portions overlapping at the junction points, which are located in the region of the frame edges.

10. Base according to one of claims 4 to 9, characterised in that the cover (2) is constructed as a heat sink for the integrated circuit that is provided with cooling ribs.

11. Base according to claim 10, characterised in that the base frame is constructed as a heat sink provided with cooling ribs.

12. Base according to claim 10 or 11, characterised in that on the bearing surfaces of the cover, the base frame has chambers (21 ... 27) for heat transfer compound for thermal coupling of frame and cover.

13. Base according to one of claims 4 to 12, characterised in that the base frame and cover overlap each other at the junction points.

14. Base according to one of claims 4 to 13, characterised in that there is provided a bottom plate (8) for mounting on the side of the printed-circuit board (9) that is opposite the frame and the cover.

15. Base according to claim 14, characterised in that the bottom plate (8) is constructed as a heat sink provided with cooling ribs and in the mounted state is thermally coupled to the integrated circuit through recesses (32, 33, 34) of the printed-circuit board via the base frame and/or the base cover.

16. Base according to claim 14 or 15, characterised in that it can be fastened by clamping the printed-circuit board between the base frame and the bottom plate.

17. Base according to claim 16, characterised in that the base frame and bottom plate can be screwed together with screws (28 ... 31) projecting through the printed-circuit board.

18. Base according to one of claims 14 to 17, characterised in that the bottom plate has a recess (41) for connection elements or components on the underside of the printed-circuit board (9) that project through the printed-circuit board.

## Revendications

1. Socle pour un circuit intégré, qui convient au montage sur une plaquette (9) à circuit imprimé et qui est muni d'un insert (7) de socle à éléments (53) de contact par lesquels des liaisons électriques entre des pins du circuit (1) intégré, réalisées pour un montage par enfichage dans une plaquette à circuit imprimé, et des éléments de raccordement de la plaquette (9) à circuit imprimé peuvent être produits, les éléments (53) de contact étant réalisés en une technique de montage en surface pour la mise en contact des éléments de raccordement sur la plaquette (9) à circuit imprimé et pouvant coulisser dans l'insert (7) de socle lors du montage pour la compensation de tolérances de hauteur des éléments de raccordement sur la plaquette (9) à circuit imprimé, caractérisé en ce que le guidage des éléments (53) de contact dans l'insert (7) de socle est réalisé de telle manière qu'ils sont empêchés de coulisser par un blocage des éléments (53) de contact dans l'insert (7) de socle après que l'insert de socle a été repoussé sur la plaquette (9) à circuit imprimé.

2. Socle suivant la revendication 1, caractérisé en ce que les éléments (53) de contact sont montés en rangées dans l'insert (7) de socle d'une manière correspondant à une disposition de pins dans le circuit (1) intégré suivant le genre d'un PGA (Pin Grid Array) ou SPGA (Staggered Pin Grid Array).

3. Culot suivant la revendication 1 ou 2, caractérisé en ce que les éléments (53) de contact pour la mise en contact des éléments de raccordement sur la plaquette (9) à circuit imprimé sont réalisés en BGA (Ball Grid Array) ou SGA (Stud Grid Array).

4. Socle suivant l'une des revendications précédentes, caractérisé en ce que le socle comporte un boîtier de blindage ouvert d'un côté en direction de la plaquette (9) à circuit imprimé et comportant un cadre (3 ... 6) et un couvercle (2) pour la réception du circuit (1) imprimé et de l'insert (7) de socle, le couvercle (2) pouvant être ouvert pour retirer le circuit (1) intégré.

5. Socle suivant la revendication 4, caractérisé en ce que le cadre (3 ... 6) de socle peut être fixé sur la plaquette (9) à circuit imprimé et, lorsqu'il est monté, bloque l'insert (7) de socle en sa position.

6. Socle suivant la revendication 5, caractérisé en ce qu'il est prévu des vis (28 ... 31) pour la fixation du cadre de socle à la plaquette à circuit imprimé.

7. Socle suivant la revendication 5 ou 6, caractérisé en ce que le cadre de socle est muni pour le blocage en position de l'insert de socle, sur sa face intérieure, d'une barrette (48) sensiblement circulaire à la face inférieure de laquelle s'applique, à l'état monté, la face supérieure d'une arête (46, 47) circulaire correspondante de l'insert (7) de socle.

8. Socle suivant l'une des revendications 4 à 7, caractérisé en ce que le cadre de socle est muni sur sa face intérieure d'au moins un évidement (42 ... 45), notamment d'un biseau, qui permet un accès pour un outil de soulèvement, notamment pour un tournevis, pour soulever le circuit (1 ) intégré.

9. Socle suivant l'une des revendications 4 à 8, caractérisé en ce que le cadre de socle est constitué d'un parallélogramme composé de plusieurs parties (3 ... 6) s'étendant chacune sensiblement le long des arêtes rectilignes, les parties se chevauchant les unes les autres au point de jointure qui se trouvent dans la zone des coins du cadre.

10. Socle suivant l'une des revendications 4 à 9, caractérisé en ce que le couvercle (2) est réalisé en élément refroidissant, muni de nervures de refroidissement, pour le circuit intégré.

11. Socle suivant la revendication 10, caractérisé en ce que le cadre de socle est réalisé en élément refroidissant, muni de nervures de refroidissement.

12. Socle suivant la revendication 10 ou 11, caractérisé en ce que le cadre de socle comporte sur les surfaces de support du couvercle des cavités (21 ... 27) pour de la pâte thermoconductrice en vue du couplage thermique du cadre et du couvercle.

13. Socle suivant l'une des revendications 4 à 12, caractérisé en ce que le cadre de socle et le couvercle se chevauchent l'un l'autre aux points de jointure.

14. Socle suivant l'une des revendications 4 à 13, caractérisé en ce qu'il est prévu une plaque (8) de fond pour le montage sur la face de la plaquette (9) à circuit imprimé qui fait face au cadre et au couvercle.

15. Socle suivant la revendication 14, caractérisé en ce que la plaque (8) de fond est réalisée en élément refroidissant, muni de nervures de refroidissement, et, à l'état monté, est couplée thermiquement avec le circuit intégré par des évidements (32, 33, 34) de la plaquette à circuit imprimé, par l'intermédiaire du cadre de socle et/ou du couvercle de socle.

16. Socle suivant la revendication 14 ou 15, caractérisé en ce qu'il peut être fixé par blocage de la plaquette à circuit imprimé entre le cadre de socle et la plaque de fond.

17. Socle suivant la revendication 16, caractérisé en ce que le cadre de socle et la plaque de fond peuvent être vissés ensemble par les vis (28 ... 31) faisant saillie de la plaquette à circuit imprimé.

18. Socle suivant l'une des revendications 14 à 17, caractérisé en ce que la plaque de fond comporte un évidement (41) pour des éléments de raccordement ou des composants faisant saillie par la plaquette à circuit imprimé sur la face inférieure de la plaquette (9) à circuit imprimé.
